# EUROPEAN PATENT SPECIFICATION

(11) **EP 2 063 530 B1**
(45) Date of publication and mention of the grant of the patent: **21.08.2013**
(21) Application number: 07828519.4
(22) Date of filing: 27.09.2007
(51) Int. Cl.: H03H 9/145, H03H 9/64, H03H 9/72, H03H 9/00

(54) **SURFACE ACOUSTIC WAVE FILTER DEVICE AND DUPLEXER**
OBERFLÄCHENWELLENFILTERGERÄT UND DUPLEXER
DISPOSITIF ET DUPLEXEUR DE FILTRE D'ONDE ACOUSTIQUE DE SURFACE

(30) Priority: 31.10.2006 JP 2006295672
(43) Date of publication of application: 27.05.2009
(73) Proprietor: Murata Manufacturing Co. Ltd., Nagaokakyo-shi, Kyoto 617-8555 (JP)
(72) Inventor: TAKAMINE, Yuichi, Nagaokakyo-shi Kyoto-fu 617-8555 (JP)
(74) Representative: Thévenet, Jean-Bruno
(86) International application number: PCT/JP2007/068773
(87) International publication number: WO 2008/053651

(56) References cited:
- WO-A1-97/00556
- WO-A1-98/34345
- WO-A1-2006/049000
- WO-A1-2006/068086
- JP-A- 08 065 098
- JP-A- 2001 308 672
- JP-A- 2001 308 672
- JP-A- 2002 314 370
- JP-A- 2006 254 410
- US-A- 5 892 418
- US-A1- 2003 174 029
- US-A1- 2004 257 172

## Description

### Technical Field

The present invention relates to a surface acoustic wave filter device having a cascade-connected structure of a plurality of surface acoustic wave filter units of longitudinally coupled resonator type and a duplexer including the surface acoustic wave filter device and, in particular, to a surface acoustic wave filter device having a surface acoustic wave resonator electrically connected between stages thereof and a duplexer including the surface acoustic wave filter device.

### Background Art

A surface acoustic wave filter device is widely used as a band filter in an RF stage of a cellular phone. There is a strong demand that this type of surface acoustic wave filter device support a high-frequency operation, and that a balanced-unbalanced transform function be incorporated in the surface acoustic wave filter device.

Recently, a frequency bandwidth used in cellular phones is wider, and a frequency band on a transmission side and a frequency band on a reception side are closer to each other. A band filter in use is required to have a wide passband and a high frequency selectivity, more specifically, the band filter in use is required to have high sharpness in filter characteristics.

To increase sharpness of the filter characteristics, a technique of connecting surface acoustic wave resonators, in series or in parallel, with surface acoustic wave filters of longitudinally coupled resonator type is widely used in the known art.

In the structure in which a surface acoustic wave resonator is connected in series with a surface acoustic wave filter of longitudinally coupled resonator type, sharpness at the high frequency side of the passband is increased by placing a resonance point of the surface acoustic wave resonator in a passband of the filter and by placing an anti-resonance point of the surface acoustic wave resonator in an attenuation region in the vicinity of a high frequency end of the filter passband.

In contrast, in the structure in which a surface acoustic wave resonator is in parallel with a surface acoustic wave filter of longitudinally coupled resonator type, sharpness at the low frequency side of the passband is increased by placing an anti-resonance point of the surface acoustic wave resonator within the filter passband and by placing a resonance point of the surface acoustic wave resonator in an attenuation region in the vicinity of a low frequency edge of the filter passband.

Whether the surface acoustic wave resonator is to be connected to an input terminal or an output terminal of the longitudinally coupled resonator type surface acoustic wave filter may be determined taking into consideration the impedances of the input terminal and the output terminal.

On the other hand, in the structure in which two stages of longitudinally coupled resonator type surface acoustic wave filters are cascade-connected, it is contemplated that a surface acoustic wave resonator is connected between the two surface acoustic wave filters, i.e., between the stages. Patent Document 1 described below discloses a longitudinally coupled resonator type surface acoustic wave filter device having a two cascade-connected structure with a surface acoustic wave resonator connected between the stages.

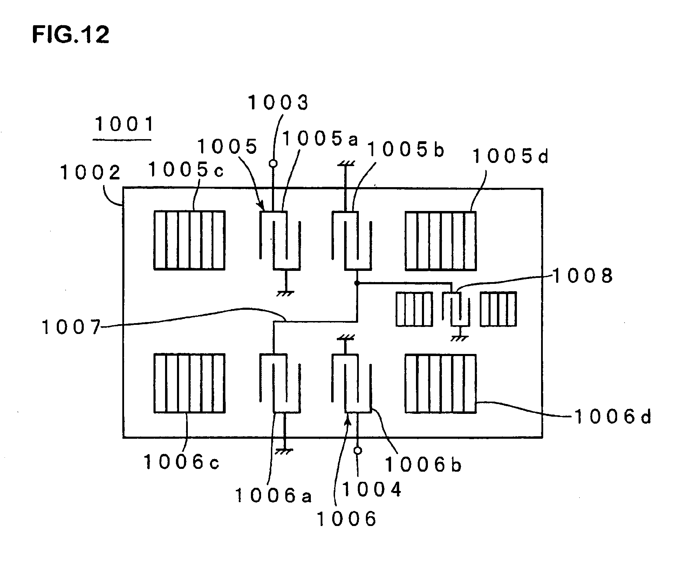

Fig. 12 is a plan view schematically illustrating a surface acoustic wave filter device described in Patent Document 1.

A surface acoustic wave filter device 1001 includes an electrode structure arranged on a piezoelectric substrate 1002 as illustrated. The surface acoustic wave filter device 1001 includes an input terminal 1003 and an output terminal 1004. First and second surface acoustic wave filter units 1005 and 1006 are connected between the input terminal 1003 and the output terminal 1004.

The first and second surface acoustic wave filter units 1005 and 1006 include respectively first and second IDTs 1005a and 1005b and first and second IDTs 1006a and 1006b, arranged to be adjacent to each other in a surface acoustic wave propagation direction. Reflectors 1005c and 1005d are arranged on both sides of an area where the IDTs 1005a and 1005b are arranged in the surface acoustic wave propagation direction. Similarly, reflectors 1006c and 1006d are arranged on both sides of an area where IDTs 1006a and 1006b are arranged in the surface acoustic wave propagation direction.

Connected to the input terminal 1003 is one end of the first IDT 1005a of the first surface acoustic wave filter unit 1005. On the other hand, one end of the second IDT 1006b of the second surface acoustic wave filter unit 1006 is connected to the output terminal 1004. One end of the second IDT 1005b is connected to one end of the first IDT 1006a via a signal line 1007, and the first and second surface acoustic wave filter units 1005 and 1006 are thus electrically connected to each other. The other end of each of IDTs 1005a, 1005b, 1006a, and 1006b is connected to the ground potential.

In the structure of the surface acoustic wave filter device 1001 in which the first and second surface acoustic wave filter units 1005 and 1006 are two-stage cascade-connected, a surface acoustic wave resonator 1008 is connected between the signal line 1007 and the ground potential. One end of the surface acoustic wave resonator 1008 is connected to the signal line 1007 and the other end of the surface acoustic wave resonator 1008 is connected to the ground potential. More specifically, the surface acoustic wave resonator 1008 between the stages is connected between the signal line and the ground potential.

An amount of attenuation is increased in the attenuation region of the high frequency side of the passband by placing the resonance point of the surface acoustic wave resonator 1008 in the attenuation region of the high frequency side of the passband. More specifically, the surface acoustic wave resonator 1008 is connected in the surface acoustic wave filter device 1001 described in Patent Document 1 not for the purpose of increasing sharpness on the low frequency side of the passband but for the purpose of increasing the amount of attenuation in the attenuation region of the high frequency side of the passband.
Patent Document 1: Japanese Unexamined Patent Application Publication (Translation of PCT Application) No. 4-54011

[0014a] WO97/00556 describes cascade-connection of various filters, including filters having a balanced-unbalanced conversion function. The applicant's earlier application JP 2001-308672 describes various SAW filter configurations having a balanced-unbalanced conversion function including one in which a resonator is connected between the balanced output terminals.

### Disclosure of Invention

In the surface acoustic wave filter device 1001 described in Patent Document 1, the surface acoustic wave resonator 1008 is connected in parallel, more specifically in parallel with the IDTs 1005b and 1006b in an inter-stage portion, and one end of the surface acoustic wave resonator 1008 is connected to the ground potential. For this reason, a capacitance of the inter-stage portion increases with regard to the ground potential, causing the passband to become narrow. The surface acoustic wave filter device cannot meet wide band requirements.

In view of the above-described related art, an object of the present invention is to provide a surface acoustic wave filter device having increased sharpness in filter characteristics and expanded passband with a structure in which a plurality of surface acoustic wave filters of longitudinally coupled resonator type are cascade-connected with a surface acoustic wave resonator connected in an inter-stage portion thereof.

The present invention provides a surface acoustic wave filter device comprising: a piezoelectric substrate, first and second surface acoustic wave filter units of longitudinally coupled resonator type, cascade-connected and arranged on the piezoelectric substrate, and at least one surface acoustic wave resonator arranged on the piezoelectric substrate, wherein each of the first and second surface acoustic wave filter units includes a first IDT, and second and third IDTs arranged on both sides of the first IDT in a surface acoustic wave propagation direction, first and second reflectors arranged in the surface acoustic wave propagation direction on both sides of an area where the first through third IDTs are arranged, the surface acoustic wave propagation directions of the first and second surface acoustic wave filter units being in parallel with each other, a first signal line electrically connecting the second IDT of the first surface acoustic wave filter unit to the second IDT of the second surface acoustic wave filter unit, and a second signal line electrically connecting the third IDT of the first surface acoustic wave filter unit to the third IDT of the second surface acoustic wave filter unit wherein an electrical signal flowing through the first signal line is different in phase by 180° from an electrical signal flowing through the second signal line characterized in that the at least one surface acoustic wave resonator is connected between the first signal line and the second signal line, the resonance point of the at least one surface acoustic wave resonator is placed within the attenuation region in the vicinity of the edge of the low frequency side of the passband of the surface acoustic wave filter device, and the anti-resonance point of the at least one surface acoustic wave resonator is placed within the passband of the surface acoustic wave filter device

[0017a] The present invention further provides a surface acoustic wave filter device comprising: a piezoelectric substrate, first and second surface acoustic wave filter units of longitudinally coupled resonator type, cascade-connected and arranged on the piezoelectric substrate, and at least one surface acoustic wave resonator arranged on the piezoelectric substrate, wherein each of the first and second surface acoustic wave filter units includes a first IDT, and second and third IDTs arranged on both sides of the first IDT in a surface acoustic wave propagation direction, first and second reflectors arranged in the surface acoustic wave propagation direction on both sides of an area where the first through third IDTs are arranged, the surface acoustic wave propagation directions of the first and second surface acoustic wave filter units being in parallel with each other, a first signal line electrically connecting the second IDT of the first surface acoustic wave filter unit to the second IDT of the second surface acoustic wave filter unit, and a second signal line electrically connecting the third IDT of the first surface acoustic wave filter unit to the third IDT of the second surface acoustic wave filter unit, wherein an electrical signal flowing through the first signal line is different in phase by 180° from an electrical signal flowing through the second signal line, characterized in that the at least one surface acoustic wave resonator is connected between the first signal line and the second signal line, the anti-resonance point of the at least one surface acoustic wave resonator is placed within the attenuation region in the vicinity of the edge of the high frequency side of the passband of the surface acoustic wave filter device, and the resonance point of the at least one surface acoustic wave resonator is placed within the passband of the surface acoustic wave filter device.

The present invention yet further provides a surface acoustic wave filter device comprising: a piezoelectric substrate, first and second surface acoustic wave 5-IDT filter units of longitudinally coupled resonator type, cascade-connected and arranged on the piezoelectric substrate, and at least two surface acoustic wave resonators arranged on the piezoelectric substrate, wherein each of the first and second surface acoustic wave filter units includes a first IDT, and second and third IDTs arranged on both sides of the first IDT in a surface acoustic wave propagation direction, fourth and fifth IDTs arranged in the surface acoustic wave propagation direction on both sides of an area where the first through third IDTs are arranged, first and second reflectors arranged in the surface acoustic wave propagation direction, each of the first IDTs of the first and second surface acoustic wave filter units including first and second sub-IDT portions that are arranged by halving the first respective IDTs in the surface acoustic wave propagation direction, the surface acoustic wave propagation directions of the first and second surface acoustic wave filter units being in parallel with each other, a first signal line electrically connecting the fourth IDTs of the first and second surface acoustic wave filter units, a second signal line electrically connecting the first sub-IDT portions of the first IDTs of the first and second surface acoustic wave filter units, a third signal line electrically connecting the second sub-IDT portions of the first IDTs of the first and second surface acoustic wave filter units, and a fourth signal line electrically connecting the fifth IDTs of the first and second surface acoustic wave filter units, wherein a phase of an electrical signal flowing through the first signal line is different by 180° from a phase of an electrical signal flowing through the second signal line, and a phase of an electrical signal flowing through the third signal line is different by 180° from a phase of an electrical signal flowing through the fourth signal line, characterized in that: at least one of the at least two surface acoustic wave resonators is electrically connected between the first signal line and the second signal line, and between the third signal line and the fourth signal line, the resonance point of the at least two surface acoustic wave resonators is placed within the attenuation region in the vicinity of the edge of the low frequency side of the passband of the surface acoustic wave filter device, and the anti-resonance point of the at least two surface acoustic wave resonators is placed within the passband of the surface acoustic wave filter device.

[0018a] The present invention still further provides a surface acoustic wave filter device comprising: a piezoelectric substrate, first and second surface acoustic wave 5-IDT filter units of longitudinally coupled resonator type, cascade-connected and arranged on the piezoelectric substrate, and at least two surface acoustic wave resonators arranged on the piezoelectric substrate, wherein each of the first and second surface acoustic wave filter units includes a first IDT, and second and third IDTs arranged on both sides of the first IDT in a surface acoustic wave propagation direction, fourth and fifth IDTs arranged in the surface acoustic wave propagation direction on both sides of an area where the first through third IDTs are arranged, first and second reflectors arranged in the surface acoustic wave propagation direction, each of the first IDTs of the first and second surface acoustic wave filter units including first and second sub-IDT portions that are arranged by halving the first respective IDTs in the surface acoustic wave propagation direction, the surface acoustic wave propagation directions of the first and second surface acoustic wave filter units being in parallel with each other, a first signal line electrically connecting the fourth IDTs of the first and second surface acoustic wave filter units, a second signal line electrically connecting the first sub-IDT portions of the first IDTs of the first and second surface acoustic wave filter units, a third signal line electrically connecting the second sub-IDT portions of the first IDTs of the first and second surface acoustic wave filter units, and a fourth signal line electrically connecting the fifth IDTs of the first and second surface acoustic wave filter units, wherein a phase of an electrical signal flowing through the first signal line is different by 180° from a phase of an electrical signal flowing through the second signal line, and a phase of an electrical signal flowing through the third signal line is different by 180° from a phase of an electrical signal flowing through the fourth signal line, characterized in that: at least one of the at least two surface acoustic wave resonators is electrically connected between the first signal line and the second signal line, and between the third signal line and the fourth signal line, the anti-resonance point of the at least two surface acoustic wave resonators is placed within the attenuation region in the vicinity of the edge of the high frequency side of the passband of the surface acoustic wave filter device, and the resonance point of the at least two surface acoustic wave resonators is placed within the passband of the surface acoustic wave filter device.

In one aspect of the present invention, the first surface acoustic wave filter unit is connected to an unbalanced terminal, and the second surface acoustic wave filter unit is connected to first and second balanced terminals. The surface acoustic wave filter device having a balanced-unbalanced transform function is thus provided.

The surface acoustic wave filter device of the present invention is not limited to the one having a balanced-unbalanced transform function. The surface acoustic wave filter device may be an unbalanced signal input unbalanced signal output filter with the first surface acoustic wave filter unit connected to a first unbalanced terminal and the second surface acoustic wave filter unit connected to a second unbalanced terminal. The surface acoustic wave filter device may be a balanced signal input (output) balanced signal output (input) filter with the first surface acoustic wave filter unit connected to first and second balanced terminals and the second surface acoustic wave filter unit connected to third and fourth balanced terminals.

In accordance with the present invention, a duplexer including as a band filter the surface acoustic wave filter device constructed in accordance with the present invention is provided. The duplexer excellent in sharpness in filter characteristics and supporting wide band design implementation is thus provided.

### Advantages

In accordance with the first invention, the first and second surface acoustic wave filter units of longitudinally coupled resonator type, are cascade-connected. Each of the first and second surface acoustic wave filter units includes the first to third IDTs. The IDTs are set up so that the phase of the signal flowing through the first signal line electrically connecting the second IDTs is inverted from the phase of the signal flowing through the second signal line electrically connecting the third IDTs. Furthermore, the surface acoustic wave resonator is connected between the first and second signal lines. This arrangement increases sharpness in the filter characteristics and widens the passband. More specifically, the signals having substantially opposite phases flow through the first and second signal lines. With the surface acoustic wave resonator connected between the first and second signal lines, the signals flowing from the first and second signal lines to the surface acoustic wave resonator cancel each other. In this way, sharpness of the filter characteristics is provided. Also, since a ground line between stages is substantially reduced, a capacitance with respect to the ground is reduced, and the passband is widened.

In the surface acoustic wave filter device of the second invention, the first and second surface acoustic wave filter units of longitudinally coupled resonator type, are cascade-connected with each unit including first through fifth IDTs. The IDTs are set up so that the signals flowing through the first signal line and the second signal line are opposite in phase to each other and so that the signals flowing through the third and fourth signal lines are opposite in phase to each other. At least one surface acoustic wave resonator is electrically connected between the first signal line and the second signal line, and between the third signal line and the fourth signal line. As in the case of the first invention, the sharpness of the filter characteristics is increased and the passband is widened.

The present invention thus provides the surface acoustic wave filter device that not only increases sharpness of the filter characteristics but also expands passband width.

### Brief Description of the Drawings

[Fig. 1] Fig. 1 is a schematic plan view illustrating a surface acoustic wave filter device in accordance with a first embodiment of the present invention.
[Fig. 2] Fig. 2 illustrates filter characteristics of surface acoustic wave filter devices of the first embodiment and a comparative example.
[Fig. 3] Fig. 3 is a schematic plan view of the surface acoustic wave filter device prepared as the comparative example.
[Fig. 4] Fig. 4 is a schematic plan view of a layout of electrodes on a piezoelectric substrate in the surface acoustic wave filter device of the first embodiment.
[Fig. 5] Fig. 5 is a schematic plan view of a layout of electrodes on a piezoelectric substrate in the surface acoustic wave filter device of the comparative example.
[Fig. 6] Fig. 6 is a schematic plan view of a surface acoustic wave filter device in accordance with a second embodiment of the present invention.
[Fig. 7] Fig. 7 is a schematic plan view of a surface acoustic wave filter device in accordance with a third embodiment of the present invention.
[Fig. 8] Fig. 8 is a schematic plan view of a surface acoustic wave filter device in accordance with a fourth embodiment of the present invention.
[Fig. 9] Fig. 9 is a schematic plan view of a surface acoustic wave filter device in accordance with a fifth embodiment of the present invention.
[Fig. 10] Fig. 10 is a schematic plan view of a surface acoustic wave filter device in accordance with a sixth embodiment of the present invention.
[Fig. 11] Fig. 11 is a schematic plan view of a surface acoustic wave filter device in accordance with a seventh embodiment of the present invention.
[Fig. 12] Fig. 12 is a schematic plan view of a surface acoustic wave filter device in the related art.

### Reference Numerals

1... Surface acoustic wave filter device
2... Piezoelectric substrate
3... Unbalanced terminal
4 and 5 ... First and second balanced terminals
6 and 7 ... First and second signal lines
6a and 7a... First and second signal lines
6b and 7b ... Third and fourth signal lines
10 and 10A... First surface acoustic wave filter units
11 to 13 and 11A to 13A ... First to third IDTs
14 and 15 ... Reflectors
20 and 20A ... Second surface acoustic wave filter units
21 to 23 and 21A to 23A ... First to third IDTs
24 and 25 ... First and second reflectors
31 ... Surface acoustic wave resonator
31a, 31b, and 31A ... Surface acoustic wave resonators
32 ... IDT
33 and 34 ... Reflectors
101 ...Surface acoustic wave filter device
110 ... First surface acoustic wave filter unit
120 ... Second surface acoustic wave filter unit
103 ... Unbalanced input terminal
104 ... Unbalanced output terminal
111 and 121 ... First IDTs
201 ... Surface acoustic wave filter device
203a and 203b ... Balanced signal input terminals
204a and 204b ... Balanced signal output terminals
210 and 220 ... First and second surface acoustic wave filter units
301 ... Surface acoustic wave filter device
401 ... Surface acoustic wave filter device
410 ... First surface acoustic wave filter unit
411 to 415 ... First to fifth IDTs
411a and 411b ... First and second sub-IDT portions
416 and 417 ... Reflectors
420 ... Second surface acoustic wave filter unit
421 to 425 ... First to fifth IDTs
421a and 421b ... First and second sub-IDT portions
426 and 427 ... Reflectors
501 ... Surface acoustic wave filter device
601 ... Duplexer
603 ... Unbalanced terminal
604 ... Surface acoustic wave resonator
605 ...Transmission side band filter
605a to 605c ... Serial arm resonators
605d and 605e ... Parallel arm resonator

### Best Mode for Carrying Out the Invention

The present invention will be clarified below by describing specific embodiments of the present invention with reference to the drawings.

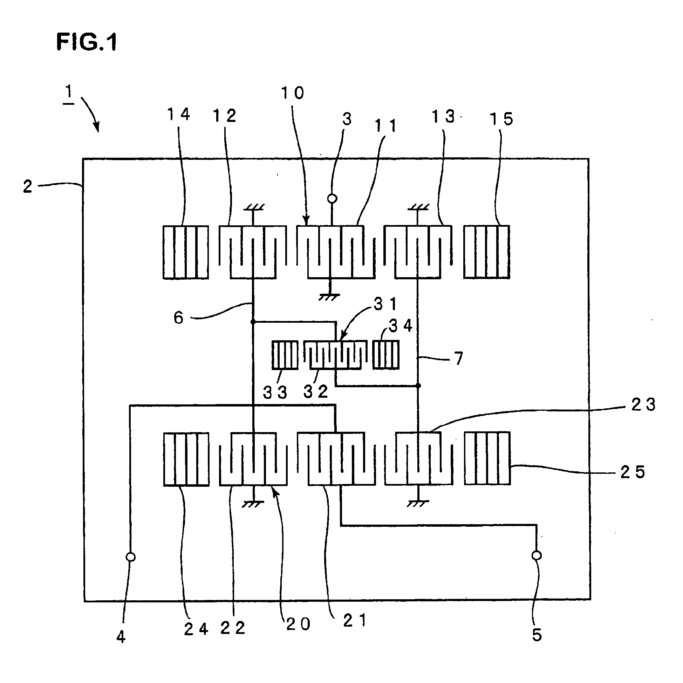

Fig. 1 is a schematic plan view of a surface acoustic wave filter device in accordance with a first embodiment of the present invention.

The surface acoustic wave filter device 1 of the present embodiment is a surface acoustic wave filter device that is used as an EGSM reception side band filter having a balanced-unbalanced transform function. The transmission frequency band in the EGSM is 880 MHz to 915 MHz while the reception frequency band is 925 MHz to 960 MHz.

The surface acoustic wave filter device 1 is constructed by forming an illustrated electrode structure on the piezoelectric substrate 2. The surface acoustic wave filter device 1 includes an unbalanced terminal 3, and first and second balanced terminals 4 and 5. In accordance with the present embodiment, the impedance of the unbalanced terminal 3 is 50 Ω, and the impedance between the first and second balanced terminals 4 and 5 is 100 Ω. The piezoelectric substrate 2 is made of but is not particularly limited to a 40°±5° Y cut X propagation LiTaO₃ substrate.

The illustrated electrode structure is formed by patterning Al on the piezoelectric substrate 2. In other words, first and second acoustic wave filter units 10 and 20 of longitudinally coupled resonator type, and a surface acoustic wave resonator 31 are thus formed.

The first acoustic wave filter unit 10 includes a first IDT 11, and second and third IDTs 12 and 13 arranged on both sides of the first IDT 11 in a surface acoustic wave propagation direction. First and second reflectors 14 and 15 are arranged on both sides of an area in the surface acoustic wave propagation direction where the first through third IDTs 11 to 13 are arranged.

Similarly, the second surface acoustic wave filter unit 20 includes a first IDT 21, and second and third IDTs 22 and 23 arranged on both sides of the first IDT 21 in the surface acoustic wave propagation direction. First and second reflectors 24 and 25 are arranged on both sides of an area in the surface acoustic wave propagation direction where the first to third IDTs 21 to 23 are arranged.

The surface acoustic wave resonator 31 is a one-port type surface acoustic wave resonator and includes an IDT 32 and reflectors 33 and 34 arranged on both sides of the IDT 32 in the surface acoustic wave propagation.

One end of the first IDT 11 in the first acoustic wave filter unit 10 is connected to the unbalanced terminal 3. The other end of the first IDT 11 is connected to the ground potential. One end of the second IDT 12 is connected to the ground potential while the other end thereof is connected to one end of the second IDT 22 in the second surface acoustic wave filter unit 20 via a first signal line 6.

One end of the third IDT 13 is connected to the ground potential while the other end thereof is connected to one end of the third IDT 23 in the second surface acoustic wave filter unit 20 via a second signal line 7. More specifically, the first signal line 6 connects the second IDTs 12 and 22, and the second signal line 7 connects the third IDTs 13 and 23.

The other end of each of the second and third IDTs 22 and 23 in the second surface acoustic wave filter unit 20 is connected to the ground potential.

One end of the first IDT 21 in the second surface acoustic wave filter unit 20 is connected to the first balanced terminal 4 while the other end thereof is connected to the second balanced terminal 5.

In accordance with the present embodiment, in an area where the first IDT 11 in the first acoustic wave filter unit 10 is adjacent to the second IDT 12, an electrode finger of the first IDT 11 is connected to the signal line, namely, to a hot voltage, and the outermost electrode finger of the second IDT 12 is connected to the ground potential. On the other hand, in an area where the IDTs 11 and 13 are adjacent to each other, both the outermost electrode finger of the first IDT 11 and the outermost electrode finger of the third IDT 13 are connected to the ground potential. The IDTs 12 and 13 are similarly constructed. The phase of a signal flowing through the second signal line 7 is different by 180° from the phase of a signal flowing through the first signal line 6.

The IDTs 22 and 23 are arranged so that the phases of the signals transmitted to the IDT 21 are different from each other by 180°.
The number of electrode fingers of the IDT 21 is an even number. The phases of the signals transmitted from the two ends of the IDT 21 to first and second balanced terminals are different from each other by 180°.

With the first to third IDTs 11 to 13 arranged as described above in accordance with the present embodiment, the phase of the signal flowing through the first signal line 6 and the phase of the signal flowing through the second signal line 7 are made different by 180°. As long as the phases of the signals flowing through the first and second signal lines 6 and 7 are different from each other by 180°, the first to third IDTs 11 to 13 may take a different configuration.

The feature of the present embodiment is that the surface acoustic wave resonator 31 is connected between the first and second signal lines 6 and 7 that are related so that the signals flowing therethrough are opposite in phase. The anti-resonance point of the surface acoustic wave resonator 31 is placed within a passband of the surface acoustic wave filter device 1 and the resonance point thereof is placed within an attenuation region in the vicinity of the edge of a low frequency side of the passband. The position of the resonance point of the surface acoustic wave resonator 31, namely, the attenuation region in the vicinity of the edge of the low frequency side of the passband refers to an attenuation range that provides increased sharpness of the filter characteristics in the low frequency side of the passband of the filter in comparison with the case in which the surface acoustic wave resonator 31 is not connected.

The surface acoustic wave filter device 1 of the present embodiment, including the surface acoustic wave resonator 31 connected between the first and second signal lines 6 and 7, not only increases sharpness in the filter characteristics in the passband low frequency side but also expands the passband. This is described on the basis of specific experiments.

The first acoustic wave filter unit 10, the second surface acoustic wave filter unit 20, and the surface acoustic wave resonator 31 were produced in accordance with the following specifications.

In the discussion that follows, wavelength λI refers to a wave determined by a pitch of electrode fingers of each IDT.

### First surface acoustic wave filter unit 10

Cross width: 36.8 λI
Number of electrode fingers of the first IDT 11: 38
Number of electrode fingers of each of the first and second IDTs 12 and 13: 28
Number of electrode fingers of each of the first and second reflectors 14 and 15: 65
Metallization ratio: 0.73
Electrode layer thickness: 0.088 λI

### Second surface acoustic wave filter unit 20

Cross width: 36.8 λI
Number of electrode fingers of the first IDT 21: 40
Number of electrode fingers of each of the first and second IDTs 22 and 23: 28
Number of electrode fingers of each of the first and second reflectors 24 and 25: 65
Metallization ratio: 0.73
Electrode layer thickness: 0.088 λI

### Specifications of the surface acoustic wave resonator 31

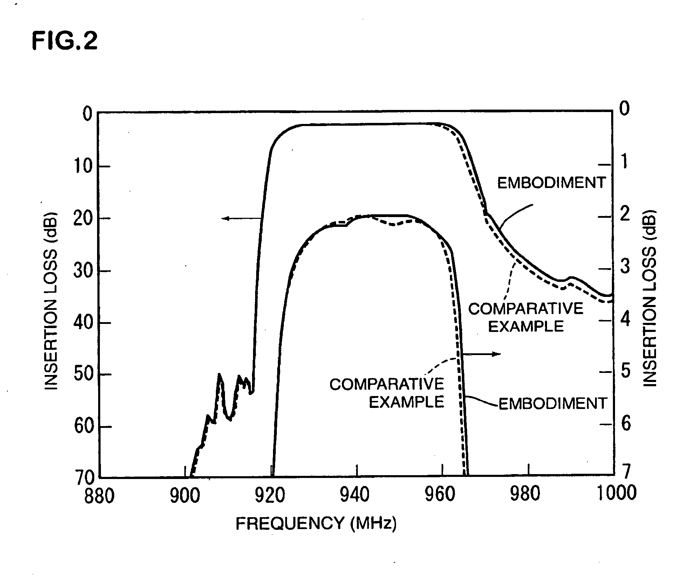

Cross width: 5.8 λI
Number of electrode fingers of the IDT 32: 61
Number of electrode fingers of each of the reflectors 33 and 34: 18
Metallization ratio: 0.50
Electrode layer thickness: 0.109 λI
The filter characteristics of the surface acoustic wave filter device 1 of the present embodiment thus produced were measured. Fig. 2 illustrates the measurement results represented by solid lines.

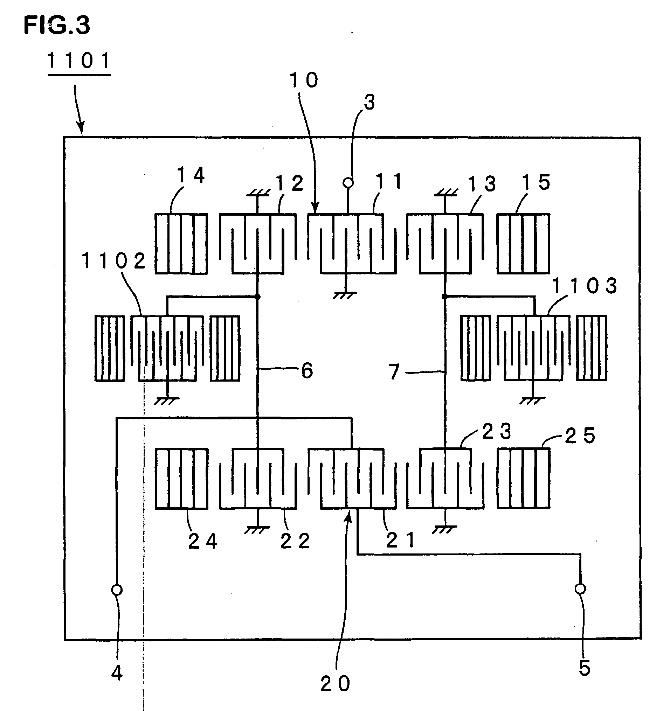

A surface acoustic wave filter device 1101 illustrated in Fig. 3 was produced as a comparative example. The surface acoustic wave filter device 1101 is similar to the surface acoustic wave filter device 1 of the present embodiment except that instead of the surface acoustic wave resonator 31, a surface acoustic wave resonator 1102 is connected between the first signal line 6 and the ground potential and a surface acoustic wave resonator 1103 is connected between the second signal line 7 and the ground potential. In this case, the electrode finger cross width in the surface acoustic wave resonators 1102 and 1103 is set to be twice the cross width of the surface acoustic wave resonator 31 illustrated in Fig. 1 in order to be equivalent to the first embodiment. The rest of design is identical to the counterpart of the first embodiment. The surface acoustic wave filter device 1101 was thus produced as a comparative example, and the filter characteristics thereof were measured. Fig. 2 illustrates the measurement results by broken lines.

As illustrated in Fig. 2, the surface acoustic wave filter device 1 provides a wider passband than the surface acoustic wave filter device 1101 as the comparative example. More specifically, the bandwidth at 3 dB attenuation, i.e., the width of the passband at an insertion loss of 3 db of the surface acoustic wave filter device 1 below a through level is wider than the comparative example by about 1.5 MHz. Sharpness of the filter characteristics at the passband low frequency side of the surface acoustic wave filter device 1 of the present embodiment remains at the same level as the comparative example.

In accordance with the present embodiment, the connection of the surface acoustic wave resonator 31 not only increases the sharpness of the filter characteristics at the passband low frequency side but also widens the passband. The possible reason for these results is described below.

As previously discussed, the surface acoustic wave resonator is connected in parallel with the surface acoustic wave filter to increase sharpness in the passband low frequency side of the filter characteristics in the related art. In such a case, the resonance point of the surface acoustic wave resonator is placed within the attenuation region in the vicinity of the passband low frequency side and the anti-resonance point is placed within the passband. In this case, however, an electrode portion of the surface acoustic wave filter connected to the ground potential becomes complex and wide as evident from the structure of the comparative example illustrated in Fig. 3, and for this reason, a capacitance of the surface acoustic wave filter becomes large with respect to the ground. In particular, if the capacitance at an inter-stage part with respect to ground is increased in the longitudinally coupled resonator type surface acoustic wave filter device 101 of two-stage cascade-connected type as illustrated in Fig. 3, the passband width is forced to be narrow. In contrast, in accordance with the present embodiment, the phase of an electrical signal flowing through the first signal line 6 is different by 180° from the phase of an electrical signal flowing through the second signal line 7. The surface acoustic wave resonator 31 is connected between the first and second signal lines 6 and 7. The signals transmitted to the surface acoustic wave resonator 31 from the first and second signal lines 6 and 7 cancel out each other.

Since the two signals cancel out each other most efficiently at the resonance point of the surface acoustic wave resonator 31, the sharpness of the low frequency side of the filter characteristics is increased in the same manner as in the surface acoustic wave filter device 1101 in which the surface acoustic wave resonators 1102 and 1103 are connected in parallel. In addition, a ground line at the inter-stage portion is substantially reduced, and the passband width is widened accordingly.

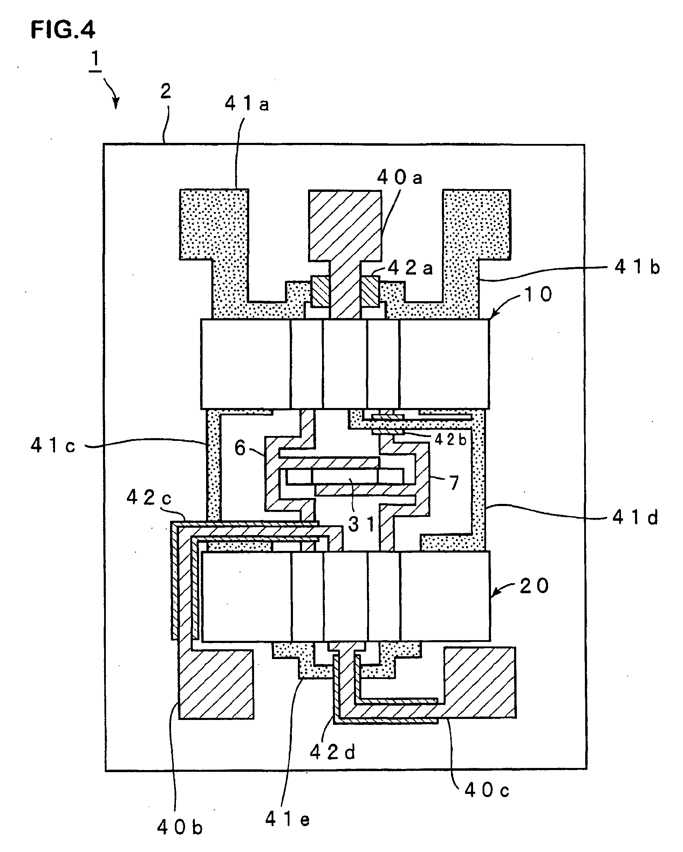

For reference purposes only, Fig. 4 schematically illustrates a layout of an electrode portion on the piezoelectric substrate 2 of the surface acoustic wave filter device 1 in accordance with the first embodiment with the electrode portion hatched. The first and second signal lines 6 and 7, electrodes 40a to 40c connected to signal potentials, and electrodes 41a to 41e connected to the ground potential, all not in sectional view, are denoted by hatching. Insulator layers 42a to 42d prevent electrodes connected to different voltages from being shortcircuited to each other.

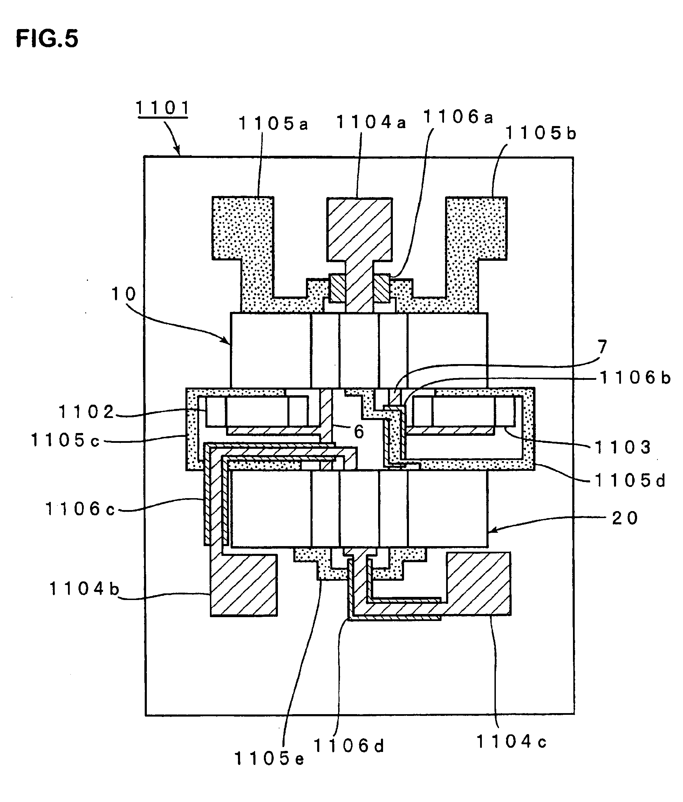

For comparison, Fig. 5 illustrates a layout of electrodes on the piezoelectric substrate in the surface acoustic wave filter device 1101 as the comparative example illustrated in Fig. 3. Also here, the first and second signal lines 6 and 7, and electrodes 1104a to 1104c and 1105a to 1105e connected to signal voltages and the ground potential are denoted by hatching. Insulator layers 1106a to 1106d prevent electrodes connected to different potentials from being shortcircuited to each other.

As is evident from the comparison of Fig. 4 and Fig. 5, the present embodiment substantially reduces the electrode area connected to the ground potential in the inter-stage region in comparison with the comparative example. A capacitance to ground is hard to be generated in the first and second signal lines 6 and 7 in the inter-stage region.

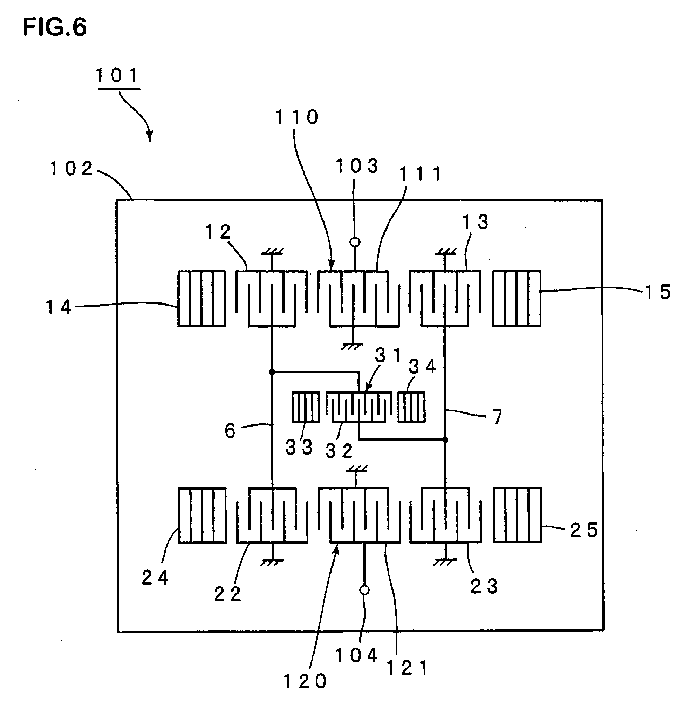

In accordance with the first embodiment, the surface acoustic wave filter device 1 has a balanced-unbalanced transform function. The present invention is not limited to the surface acoustic wave filter device having the balanced-unbalanced transform function. More specifically, an illustrated electrode structure is formed on a piezoelectric substrate 102 in the surface acoustic wave filter device 101 of a second embodiment as illustrated in Fig. 6. Here, first and second surface acoustic wave filter units 110 and 120 are cascade-connected between an unbalanced input terminal 103 and an unbalanced output terminal 104. In other words, one end of a first IDT 111 in the first surface acoustic wave filter unit 110 is connected to the unbalanced input terminal 103, and the other end thereof is connected to the ground potential. Also, one end of a first IDT 121 in the second surface acoustic wave filter unit 120 is connected to the ground potential and the other end thereof is connected to the unbalanced output terminal 104. The rest of the structure of the surface acoustic wave filter device 101 remains unchanged from that of the surface acoustic wave filter device 1 of the first embodiment. The same reference numerals are given to the same structure elements, and the discussion thereof is omitted herein.

In this way, the surface acoustic wave filter device may be a surface acoustic wave filter device having an unbalanced signal input and an unbalanced signal output.

Since the surface acoustic wave resonator 31 is connected between the first and second signal lines 6 and 7 in the second embodiment, the phases of the signals flowing through the first and second signal lines 6 and 7 are different from each other by 180°. Furthermore, the resonance point of the surface acoustic wave resonator 31 is placed within the attenuation region in the vicinity of the edge of the passband low frequency side and the anti-resonance point thereof is placed within the passband. For this reason, as in the first embodiment, the sharpness of the filter characteristics in the passband low frequency side is increased, and the passband width is increased.

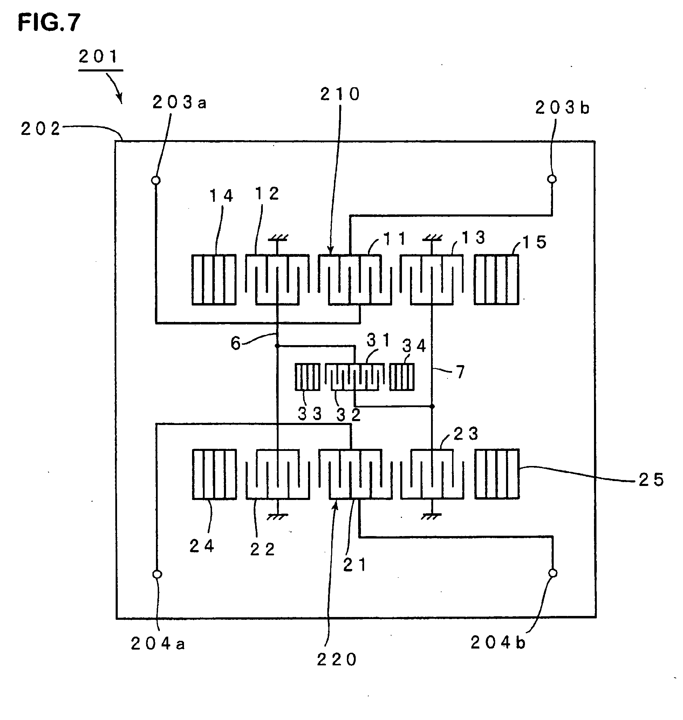

A surface acoustic wave filter device 201 of a third embodiment illustrated in Fig. 7 includes an illustrated electrode structure formed on a piezoelectric substrate 202. More specifically, first and second surface acoustic wave filter units 210 and 220 are cascade-connected between first and second balanced signal input terminals 203a and 203b and first and second balanced signal output terminals 204a and 204b. As in the first embodiment, the surface acoustic wave resonator 31 is constructed and connected in the inter-stage portion.

The surface acoustic wave filter units 210 and 220 are constructed in the same way as the first and second acoustic wave filter units 10 and 20 in the first embodiment. However, it is noted that one end of the first IDT 11 is connected to the first balanced signal input terminal 203a and that the other end of the first IDT 11 is connected to the second balanced signal input terminal 203b. In the second surface acoustic wave filter unit 220, one end of the central first IDT 21 is connected to the first balanced signal output terminal 204a and the other end thereof is connected to the second balanced signal output terminal 204b. The rest of the structure of the surface acoustic wave filter device 201 remains unchanged from that of the surface acoustic wave filter device 1 of the first embodiment. As the first embodiment, the third embodiment provides an increased sharpness of the filter characteristics in the passband low frequency side and an increased passband width.

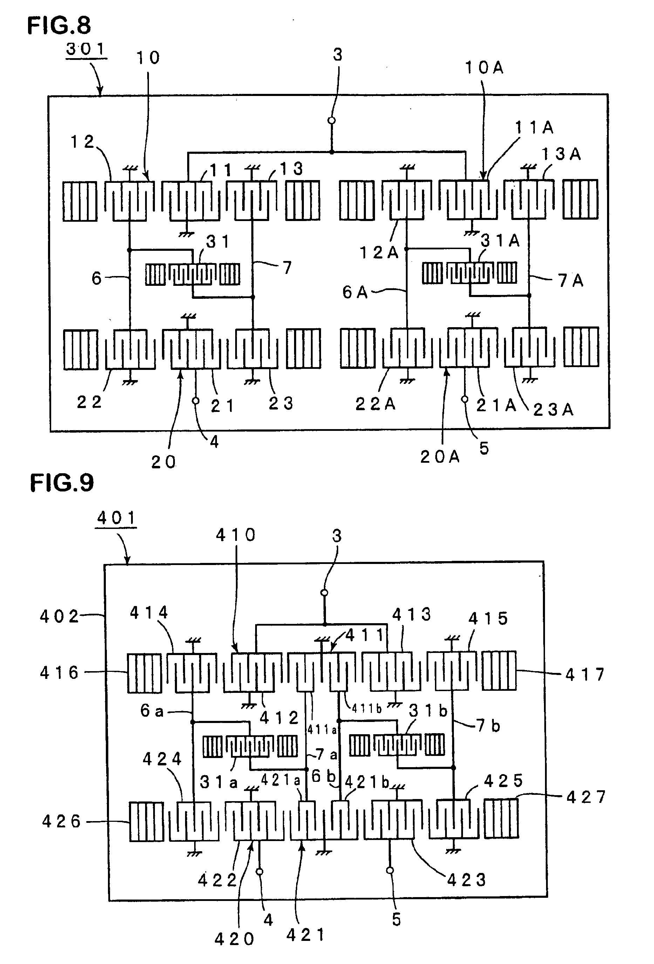

Fig. 8 is a schematic plan view illustrating an electrode structure of a surface acoustic wave filter device in accordance with a fourth embodiment of the present invention. The surface acoustic wave filter device 301 of the fourth embodiment includes two first 3-IDT acoustic wave filter units 10 and 10A of longitudinally coupled resonator type connected to the unbalanced terminal 3. The second surface acoustic wave filter unit 20 of longitudinally coupled resonator type is connected as a subsequent stage to the first acoustic wave filter unit 10. The surface acoustic wave resonator 31 is connected between the first and second signal lines 6 and 7. One end of the first IDT 21 in the second surface acoustic wave filter unit 20 is electrically connected to the ground potential and the other end thereof is electrically connected to the first balanced terminal 4.

On the other hand, the second 3-IDT surface acoustic wave filter unit 20A of longitudinally coupled resonator type is connected as a subsequent stage to the first acoustic wave filter unit 10A. A surface acoustic wave resonator 31A is connected between first and second signal lines 6A and 7A. One end of the first IDT 21A in the second surface acoustic wave filter unit 20A is connected to the ground potential and the other end thereof is connected to the second balanced terminal 5.

In accordance with the fourth embodiment, the IDTs 11 to 13, 11A to 13A, and 21 to 23, and 21A to 23A are constructed so that the phases of the signals flowing through the first and second signal lines 6 and 7 are different from each other by 180°, so that the phases of the signals flowing through the first and second signal lines 6A and 7A are different from each other by 180°, and so that the phases of the signals picked up from the first and second balanced terminals 4 and 5 are different from each other by 180°. Furthermore, as the surface acoustic wave resonator 31, the surface acoustic wave resonator 31A has the resonance point thereof within the attenuation region in the vicinity of the edge of the low frequency side of the passband of the filter and the anti-resonance point thereof within the passband. In accordance with the fourth embodiment, the sharpness of the filter characteristics in the passband low frequency side is increased and the passband width is increased.

The present invention is not limited to the surface acoustic wave filter device having a float balanced type balanced-unbalanced transform function illustrated in Fig. 1. The present invention may be applicable to a surface acoustic wave filter device such as the surface acoustic wave filter device 301 of the fourth embodiment having a neutral point type balanced-unbalanced transform function.

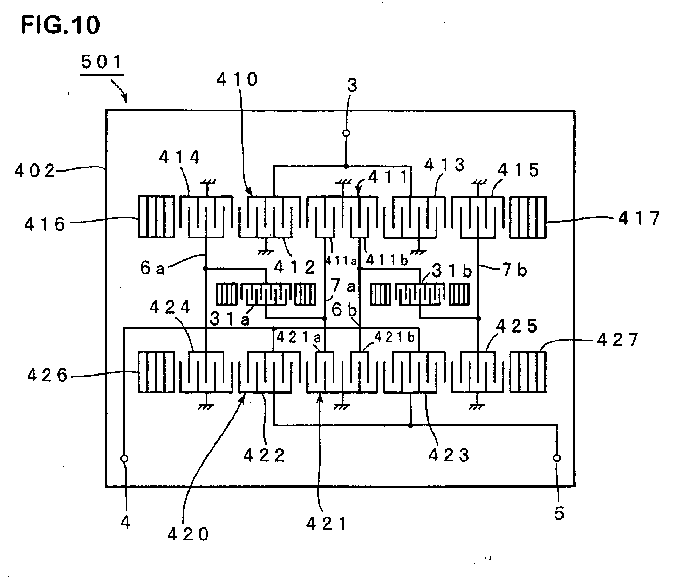

Also, with reference to Fig. 9 and Fig. 10, the present invention is also applicable to a surface acoustic wave filter device including a longitudinally coupled resonator type 5-IDT surface acoustic wave filter.

A surface acoustic wave filter device 401 of a fifth embodiment illustrated in Fig. 9 includes an illustrated electrode structure formed on a piezoelectric substrate 402. First and second surface acoustic wave 5-IDT filter units 410 and 420 of longitudinally coupled resonator type are cascade-connected between a unbalanced terminal 3 and first and second balanced terminals 4 and 5.

The first surface acoustic wave filter unit 410 includes a first IDT 411, second and third IDTs 412 and 413 arranged on both sides in the surface acoustic wave propagation direction of the first IDT 411, and a fourth IDT 414 and a fifth IDT 415 arranged on both sides in the surface acoustic wave propagation direction of an area where the first to third IDTs 411 to 413 are arranged. First and second reflectors 416 and 417 are arranged respectively on both sides in the surface acoustic wave propagation direction of the fourth and fifth IDTs 414 and 415.

The second surface acoustic wave filter unit 420 includes first to fifth IDTs 421 to 425 and first and second reflectors 426 and 427.

The central first IDTs 411 and 421 respectively include first and second sub-IDT portions 411a and 411b and 421a and 421b that are produced by splitting the first IDTs 411 and 421 in the surface acoustic wave propagation direction.

One end of each of the second and third IDTs 412 and 413 is connected to the unbalanced terminal 3 and the other ends of the second and third IDTs 412 and 413 are connected to the ground potential. One end of the fourth IDT 414 is connected to one end of the fourth IDT 424 in the second surface acoustic wave filter unit 420 via the first signal line 6a. The other ends of the IDTs 414 and 424 are respectively connected to the ground potential. One end of the first sub-IDT portion 411a is connected to the first sub-IDT portion 421a via the second signal line 7a.

The second sub-IDT portion 411b is electrically connected to the second sub-IDT portion 421b via a third signal line 6b. The ends of the IDTs 411 and 421 opposite to the sub-IDT portions thereof are connected the ground potential. One end of the fifth IDT 415 is connected to one end of the fifth IDT 425 via a fourth signal line 7b. The other ends of the fifth IDTs 415 and 425 are respectively connected to the ground potential.

One end of the second IDT 422 is connected to the ground potential and the other end thereof is connected to the first balanced terminal 4. Similarly, one end of the third IDT 423 is connected to the ground potential, and the other end thereof is connected to the second balanced terminal 5. The IDTs 411 to 415 and IDTs 421 to 425 are arranged so that the phase of the signal flowing through the first signal line 6a and the phase of the signal flowing through the second signal line 7a are different from each other by 180°, the phase of the signal flowing through the third signal line 6b and the phase of the signal flowing through the fourth signal line 7b are different from each other by 180°, and the phases of the signals picked up from the first and second balanced terminals 4 and 5 are different from each other by 180°.

Furthermore, the surface acoustic wave resonator 31a is connected between the first and second signal lines 6 and 7, and the surface acoustic wave resonator 31b is connected between the first and second signal lines 6b and 7b.

In accordance with the present embodiment, the resonance points of the surface acoustic wave resonators 31a and 31b are placed within the attenuation region in the vicinity of the edge of the low frequency side of the passband, and the anti-resonance points thereof are placed within the passband. In accordance with the present embodiment, the sharpness of the filter characteristics is increased in the passband low frequency side and the passband width is increased.

The surface acoustic wave filter device 501 illustrated in Fig. 10 is identical in structure to the surface acoustic wave filter device 401 except that the connection of the unbalanced terminal 3, and the first and second balanced terminals 4 and 5 is different. More specifically, the surface acoustic wave filter device 501 of a fifth embodiment of the present invention is identical in structure to the surface acoustic wave filter device 401 except that the first balanced terminal 4 is electrically connected to one end of each of the second and third IDTs 422 and 423, and that the second balanced terminal 5 is electrically connected to the other ends of the second and third IDTs 422 and 423. In this way, in the surface acoustic wave filter device including the longitudinally coupled resonator type resonator type, surface acoustic wave 5-IDT filter, the connection type of the first and second balanced terminals for performing the balanced-unbalanced transform function may be a float balanced type.

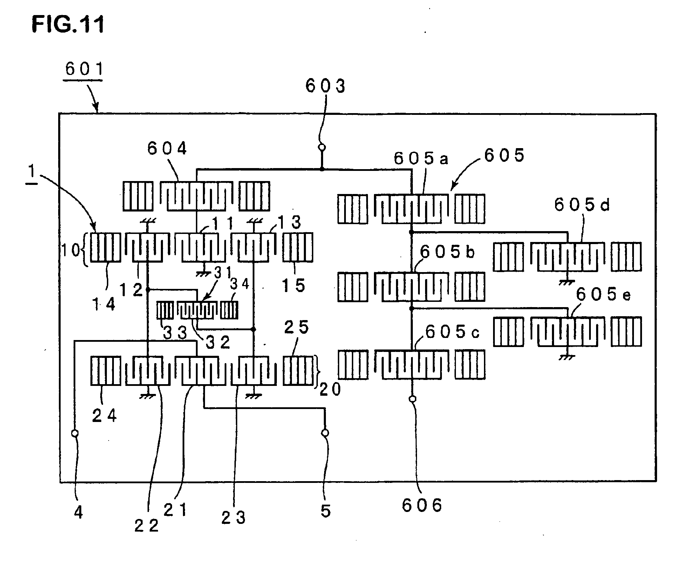

The surface acoustic wave filter device of the present invention is preferably used as a band filter for an RF stage in a cellular phone. In particular, the surface acoustic wave filter device is preferably used for a duplexer 601 illustrated in Fig. 11. In the duplexer 601, the surface acoustic wave filter device 1 of the first embodiment is connected via a surface acoustic wave resonator 604 to an unbalanced terminal 603 connected to an antenna. With this arrangement, a reception side band filter having the first and second balanced terminals 4 and 5 as receiving terminals is provided. On the other hand, a transmission side band filter 605 is connected to the unbalanced terminal 603 connected to the antenna. In accordance with the present embodiment, the transmission side band filter 605 has a ladder type circuit arrangement that includes a plurality of serial arm resonators 605a to 605c, and a plurality of parallel arm resonators 605d and 605e. The plurality of serial arm resonators 605a to 605c are connected between a transmission side terminal 606 and the unbalanced terminal 603.

In accordance with the first embodiment, the piezoelectric substrate is a 40°±5° Y cut X propagation LiTaO₃ substrate. In accordance with the present invention, the piezoelectric substrate may be another piezoelectric substrate having a different cut angle, such as 64° to 72° Y cut X propagation LiNbO₃ substrate, a 41° Y cut X propagation LiNbO₃ substrate, or may be a different piezoelectric substrate made of a different piezoelectric material.

In each of the surface acoustic wave resonators 31, 31A, 31a, and 31b in the above-described embodiments, the resonance point thereof is placed within the attenuation region in the vicinity of the edge of the passband low frequency side, and the anti-resonance point thereof is placed within the passband. The sharpness of the filter characteristics on the passband low frequency side is increased. The present invention is not limited to this arrangement. The resonance point may be placed within the passband and the anti-resonance point may be placed within the attenuation region in the vicinity of the passband high frequency side so that an amount of attenuation is increased within the attenuation region in the vicinity of the edge of the passband high frequency side.

## Claims

1. A surface acoustic wave filter device (1) comprising:
a piezoelectric substrate (2),
first and second surface acoustic wave filter units (10,20) of longitudinally coupled resonator type, cascade-connected and arranged on the piezoelectric substrate, and
at least one surface acoustic wave resonator (31) arranged on the piezoelectric substrate,
wherein each of the first and second surface acoustic wave filter units (10/20) includes a first IDT (11/21), and second and third IDTs (12,13/22,23) arranged on both sides of the first IDT in a surface acoustic wave propagation direction, first and second reflectors (14,15/24,25) arranged in the surface acoustic wave propagation direction on both sides of an area where the first through third IDTs are arranged, the surface acoustic wave propagation directions of the first and second surface acoustic wave filter units (10,20) being in parallel with each other,
a first signal line (6) electrically connecting the second IDT (12) of the first surface acoustic wave filter unit to the second IDT (22) of the second surface acoustic wave filter unit, and
a second signal line (7) electrically connecting the third IDT (13) of the first surface acoustic wave filter unit to the third IDT (23) of the second surface acoustic wave filter unit,
wherein an electrical signal flowing through the first signal line (6) is different in phase by 180° from an electrical signal flowing through the second signal line (7),
**characterized in that** the at least one surface acoustic wave resonator (31) is connected between the first signal line (6) and the second signal line (7), the resonance point of the at least one surface acoustic wave resonator (31) is placed within the attenuation region in the vicinity of the edge of the low frequency side of the passband of the surface acoustic wave filter device (1), and the anti-resonance point of the at least one surface acoustic wave resonator (31) is placed within the passband of the surface acoustic wave filter device (1).

2. A surface acoustic wave filter device (1) comprising:
a piezoelectric substrate (2),
first and second surface acoustic wave filter units (10,20) of longitudinally coupled resonator type, cascade-connected and arranged on the piezoelectric substrate, and
at least one surface acoustic wave resonator (31) arranged on the piezoelectric substrate,
wherein each of the first and second surface acoustic wave filter units (10/20) includes a first IDT (11/21), and second and third IDTs (12,13/22,23) arranged on both sides of the first IDT in a surface acoustic wave propagation direction, first and second reflectors (14,15/24,25) arranged in the surface acoustic wave propagation direction on both sides of an area where the first through third IDTs are arranged, the surface acoustic wave propagation directions of the first and second surface acoustic wave filter units (10,20) being in parallel with each other,
a first signal line (6) electrically connecting the second IDT (12) of the first surface acoustic wave filter unit to the second IDT (22) of the second surface acoustic wave filter unit, and
a second signal line (7) electrically connecting the third IDT (13) of the first surface acoustic wave filter unit to the third IDT (23) of the second surface acoustic wave filter unit,
wherein an electrical signal flowing through the first signal line (6) is different in phase by 180° from an electrical signal flowing through the second signal line (7),
**characterized in that** the at least one surface acoustic wave resonator (31) is connected between the first signal line (6) and the second signal line (7), the anti-resonance point of the at least one surface acoustic wave resonator (31) is placed within the attenuation region in the vicinity of the edge of the high frequency side of the passband of the surface acoustic wave filter device (1), and the resonance point of the at least one surface acoustic wave resonator (31) is placed within the passband of the surface acoustic wave filter device (1).

3. A surface acoustic wave filter device (401) comprising:
a piezoelectric substrate (402),
first and second surface acoustic wave 5-IDT filter units (410,420) of longitudinally coupled resonator type, cascade-connected and arranged on the piezoelectric substrate, and
at least two surface acoustic wave resonators (31a,31b) arranged on the piezoelectric substrate,
wherein each of the first and second surface acoustic wave filter units (410/420) includes a first IDT (411/421), and second and third IDTs (412,413/422,423) arranged on both sides of the first IDT in a surface acoustic wave propagation direction, fourth and fifth IDTs (414,415/424,425) arranged in the surface acoustic wave propagation direction on both sides of an area where the first through third IDTs are arranged, first and second reflectors (416,417/426,427) arranged in the surface acoustic wave propagation direction, each of the first IDTs of the first and second surface acoustic wave filter units (410/420) including first and second sub-IDT portions (411a,411b/421a,421b) that are arranged by halving the first respective IDTs in the surface acoustic wave propagation direction,
the surface acoustic wave propagation directions of the first and second surface acoustic wave filter units (410,420) being in parallel with each other,
a first signal line (6a) electrically connecting the fourth IDTs (414,424) of the first and second surface acoustic wave filter units, a second signal line (7a) electrically connecting the first sub-IDT portions (411a,421a) of the first IDTs of the first and second surface acoustic wave filter units, a third signal line (6b) electrically connecting the second sub-IDT portions (411b,421b) of the first IDTs of the first and second surface acoustic wave filter units, and a fourth signal line (7b) electrically connecting the fifth IDTs (415,425) of the first and second surface acoustic wave filter units,
wherein a phase of an electrical signal flowing through the first signal line (6a) is different by 180° from a phase of an electrical signal flowing through the second signal line (7a), and a phase of an electrical signal flowing through the third signal line (6b) is different by 180° from a phase of an electrical signal flowing through the fourth signal line (7b),
**characterized in that**:
at least one (31a/31b) of the at least two surface acoustic wave resonators is electrically connected between the first signal line (6a) and the second signal line (7a), and between the third signal line (6b) and the fourth signal line (7b),
the resonance point of the at least two surface acoustic wave resonators is placed within the attenuation region in the vicinity of the edge of the low frequency side of the passband of the surface acoustic wave filter device (401), and
the anti-resonance point of the at least two surface acoustic wave resonators is placed within the passband of the surface acoustic wave filter device (401).

4. A surface acoustic wave filter device (401) comprising:
a piezoelectric substrate (402),
first and second surface acoustic wave 5-IDT filter units (410,420) of longitudinally coupled resonator type, cascade-connected and arranged on the piezoelectric substrate, and
at least two surface acoustic wave resonators (31a,31b) arranged on the piezoelectric substrate,
wherein each of the first and second surface acoustic wave filter units (410/420) includes a first IDT (411/421), and second and third IDTs (412,413/422,423) arranged on both sides of the first IDT in a surface acoustic wave propagation direction, fourth and fifth IDTs (414,415/424,425) arranged in the surface acoustic wave propagation direction on both sides of an area where the first through third IDTs are arranged, first and second reflectors (416,417/426,427) arranged in the surface acoustic wave propagation direction, each of the first IDTs of the first and second surface acoustic wave filter units (410/420) including first and second sub-IDT portions (411a,411b/421a,421b) that are arranged by halving the first respective IDTs in the surface acoustic wave propagation direction,
the surface acoustic wave propagation directions of the first and second surface acoustic wave filter units (410,420) being in parallel with each other,
a first signal line (6a) electrically connecting the fourth IDTs (414,424) of the first and second surface acoustic wave filter units, a second signal line (7a) electrically connecting the first sub-IDT portions (411a,421a) of the first IDTs of the first and second surface acoustic wave filter units, a third signal line (6b) electrically connecting the second sub-IDT portions (411b,421b) of the first IDTs of the first and second surface acoustic wave filter units, and a fourth signal line (7b) electrically connecting the fifth IDTs (415,425) of the first and second surface acoustic wave filter units,
wherein a phase of an electrical signal flowing through the first signal line (6a) is different by 180° from a phase of an electrical signal flowing through the second signal line (7a), and a phase of an electrical signal flowing through the third signal line (6b) is different by 180° from a phase of an electrical signal flowing through the fourth signal line (7b),
**characterized in that**:
at least one (31a/31b) of the at least two surface acoustic wave resonators is electrically connected between the first signal line (6a) and the second signal line (7a), and between the third signal line (6b) and the fourth signal line (7b),
the anti-resonance point of the at least two surface acoustic wave resonators is placed within the attenuation region in the vicinity of the edge of the high frequency side of the passband of the surface acoustic wave filter device (401), and
the resonance point of the at least two surface acoustic wave resonators is placed within the passband of the surface acoustic wave filter device (401).

5. The surface acoustic wave filter device according to one of claims 1 to 4, wherein the surface acoustic wave filter device has a balanced-unbalanced transform function with the first surface acoustic wave filter unit (10/410) connected to an unbalanced terminal (3), and the second surface acoustic wave filter unit (20/420) connected to first and second balanced terminals (4,5).

6. The surface acoustic wave filter device (101) according to one of claims 1 to 4, wherein the surface acoustic wave filter device is an unbalanced signal input unbalanced signal output filter with the first surface acoustic wave filter unit (110) connected to a first unbalanced terminal (103) and the second surface acoustic wave filter unit (120) connected to a second unbalanced terminal (104).

7. The surface acoustic wave filter device (201) according to one of claims 1 to 4, wherein the surface acoustic wave filter device is a balanced signal input balanced signal output filter with the first surface acoustic wave filter unit (210) connected to first and second balanced terminals (203a,203b) and the second surface acoustic wave filter unit (220) connected to third and fourth balanced terminals (204a,204b).

8. A duplexer (601) comprising as a band filter the surface acoustic wave filter device (1) according to one of claims 1 to 7.

## Patentansprüche

1. Akustische Oberflächenwellenfiltervorrichtung (1) umfassend:
ein piezoelektrisches Substrat (2),
erste und zweite akustische Oberflächenwellenfiltereinheiten (10; 20) vom längsgekoppelten Resonatortyp, die kaskadiert geschaltet und auf dem piezoelektrischen Substrat angeordnet sind, und
wenigstens einen akustischen Oberflächenwellenresonator (31), der auf dem piezoelektrischen Substrat angeordnet ist,
wobei jede der ersten und zweiten akustischen Oberflächenwellenfiltereinheiten (10; 20) eine erste IDT (11; 21) und zweite und dritte IDTs (12, 13; 22, 23), die auf beiden Seiten der ersten IDT in einer akustischen Oberflächenwellenausbreitungsrichtung angeordnet sind, und erste und zweite Reflektoren (14, 15; 24, 25) umfaßt, die in der akustischen Oberflächenwellenausbreitungsrichtung auf beiden Seiten eines Bereichs angeordnet sind, in dem die ersten bis dritten IDTs angeordnet sind, wobei die akustischen Oberflächenwellenausbreitungsrichtungen der ersten und zweiten akustischen Oberflächenwellenfiltereinheiten (10; 20) parallel zueinander verlaufen,
eine erste Signalleitung (6), die die zweite IDT (12) der ersten akustischen Oberflächenwellenfiltereinheit mit der zweiten IDT (22) der zweiten akustischen Oberflächenwellenfiltereinheit elektrisch verbindet, und
eine zweite Signalleitung (7), die die dritte IDT (13) der ersten akustischen Oberflächenwellenfiltereinheit mit der dritten IDT (23) der zweiten akustischen Oberflächenwellenfiltereinheit elektrisch verbindet,
wobei ein elektrisches Signal, das durch die erste Signalleitung (6) läuft, von einem elektrischen Signal, das durch die zweite Signalleitung (7) läuft, um 180° phasenverschoben ist,
**dadurch gekennzeichnet, daß** der wenigstens eine akustische Oberflächenwellenresonator (31) zwischen die erste Signalleitung (6) und die zweite Signalleitung (7) geschaltet ist, der Resonanzpunkt des wenigstens einen akustischen Oberflächenwellenresonators (31) innerhalb der Dämpfungsregion in der Nachbarschaft des Randes der Niedrigfrequenzseite des Durchlaßbandes der akustischen Oberflächenwellenfiltervorrichtung (1) plaziert ist und der Antiresonanzpunkt des wenigstens einen akustischen Oberflächenwellenresonators (31) innerhalb des Durchlaßbandes der akustischen Oberflächenwellenfiltervorrichtung (1) plaziert ist.

2. Akustische Oberflächenwellenfiltervorrichtung (1) umfassend:
ein piezoelektrisches Substrat (2),
erste und zweite akustische Oberflächenwellenfiltereinheiten (10; 20) vom längsgekoppelten Resonatortyp, die kaskadiert geschaltet und auf dem piezoelektrischen Substrat angeordnet sind, und
wenigstens einen akustischen Oberflächenwellenresonator (31), der auf dem piezoelektrischen Substrat angeordnet ist,
wobei jede der ersten und zweiten akustischen Oberflächenwellenfiltereinheiten (10; 20) eine erste IDT (11; 21) und zweite und dritte IDTs (12, 13; 22, 23), die auf beiden Seiten der ersten IDT in einer akustischen
Oberflächenwellenausbreitungsrichtung angeordnet sind, und erste und zweite Reflektoren (14, 15; 24, 25) umfaßt, die in der akustischen Oberflächenwellenausbreitungsrichtung auf beiden Seiten eines Bereichs angeordnet sind, in dem die ersten bis dritten IDTs angeordnet sind, wobei die akustischen Oberflächenwellenausbreitungsrichtungen der ersten und zweiten akustischen Oberflächenwellenfiltereinheiten (10; 20) parallel zueinander verlaufen,
eine erste Signalleitung (6), die die zweite IDT (12) der ersten akustischen Oberflächenwellenfiltereinheit mit der zweiten IDT (22) der zweiten akustischen Oberflächenwellenfiltereinheit elektrisch verbindet, und
eine zweite Signalleitung (7), die die dritte IDT (13) der ersten akustischen Oberflächenwellenfiltereinheit mit der dritten IDT (23) der zweiten akustischen Oberflächenwellenfiltereinheit elektrisch verbindet,
wobei ein elektrisches Signal, das durch die erste Signalleitung (6) läuft, von einem elektrischen Signal, das durch die zweite Signalleitung (7) läuft, um 180° phasenverschoben ist,
**dadurch gekennzeichnet, daß** der wenigstens eine akustische Oberflächenwellenresonator (31) zwischen die erste Signalleitung (6) und die zweite Signalleitung (7) geschaltet ist, der Antiresonanzpunkt des wenigstens einen akustischen Oberflächenwellenresonators (31) innerhalb der Dämpfungsregion in der Nachbarschaft des Randes der Niedrigfrequenzseite des Durchlaßbandes der akustischen Oberflächenwellenfiltervorrichtung (1) plaziert ist und der Resonanzpunkt des wenigstens einen akustischen Oberflächenwellenresonators (31) innerhalb des Durchlaßbandes der akustischen Oberflächenwellenfiltervorrichtung (1) plaziert ist.

3. Akustische Oberflächenwellenfiltervorrichtung (401) umfassend:
ein piezoelektrisches Substrat (402),
erste und zweite akustische Oberflächenwellen-5-IDT-Filtereinheiten (410; 420) vom längsgekoppelten Resonatortyp, die kaskadiert geschaltet und auf dem piezoelektrischen Substrat angeordnet sind, und
wenigstens zwei akustische Oberflächenwellenresonatoren (31 a, 31 b), die auf dem piezoelektrischen Substrat angeordnet sind,
wobei jede der ersten und zweiten akustischen Oberflächenwellenfiltereinheiten (410; 420) eine erste IDT (411; 421) und zweite und dritte IDTs (412, 413; 422, 423), die auf beiden Seiten der ersten IDT in einer akustischen Oberflächenwellenausbreitungsrichtung angeordnet sind, vierte und fünfte IDTs (414, 415; 424, 425), die in der akustischen Oberflächenwellenausbreitungsrichtung auf beiden Seiten eines Bereichs angeordnet sind, in dem die ersten bis dritten IDTs angeordnet sind, und erste und zweite Reflektoren (416, 417; 426, 427) umfaßt, die in der akustischen Oberflächenwellenausbreitungsrichtung angeordnet sind, wobei jeweils die ersten IDTs der ersten und zweiten akustischen Oberflächenwellenfiltereinheiten (410; 420) erste und zweite IDT-Unterabschnitte (411a, 411b; 421 a, 421 b) umfassen, die unter Halbieren der entsprechenden IDTs in der akustischen Oberflächenwellenausbreitungsrichtung angeordnet sind,
wobei die akustischen Oberflächenwellenausbreitungsrichtungen der ersten und zweiten akustischen Oberflächenwellenfiltereinheiten (410; 420) parallel zueinander verlaufen,
eine erste Signalleitung (6a), die die vierten IDTs (414; 424) der ersten und zweiten akustischen Oberflächenwellenfiltereinheiten elektrisch verbindet, eine zweite Signalleitung (7a), die die ersten IDT-Unterabschnitte (411a; 421 a) der ersten IDTs der ersten und zweiten akustischen Oberflächenwellenfiltereinheiten elektrisch verbindet, eine dritte Signalleitung (6b), die die zweiten IDT-Unterabschnitte (411b; 421 b) der ersten IDTs der ersten und zweiten akustischen Oberflächenwellenfiltereinheiten elektrisch verbindet, und eine vierte Signalleitung (7b), die die fünften IDTs (415; 425) der ersten und zweiten akustischen Oberflächenwellenfiltereinheiten elektrisch verbindet,
wobei eine Phase eines elektrischen Signals, das durch die erste Signalleitung (6a) läuft, von einer Phase eines elektrischen Signals, das durch die zweite Signalleitung (7a) läuft, um 180° verschoben ist, und eine Phase eines elektrischen Signals, das durch die dritte Signalleitung (6b) läuft, von einer Phase eines elektrischen Signals, das durch die vierte Signalleitung (7b) läuft, um 180° verschoben ist,
**dadurch gekennzeichnet, daß**
wenigstens einer (31 a; 31 b) der wenigstens zwei akustischen Oberflächenwellenresonatoren zwischen die erste Signalleitung (6a) und die zweite Signalleitung (7a) und zwischen die dritte Signalleitung (6b) und die vierte Signalleitung (7b) elektrisch geschaltet ist,
der Resonanzpunkt der wenigstens zwei akustischen Oberflächenwellenresonatoren innerhalb der Dämpfungsregion in der Nachbarschaft des Randes der Niedrigfrequenzseite des Durchlaßbandes der akustischen Oberflächenwellenfiltervorrichtung (401) plaziert ist und
der Antiresonanzpunkt der wenigstens zwei akustischen Oberflächenwellenresonatoren innerhalb des Durchlaßbandes der akustischen Oberflächenwellenfiltervorrichtung (401) plaziert ist.

4. Akustische Oberflächenwellenfiltervorrichtung (401) umfassend:
ein piezoelektrisches Substrat (402),
erste und zweite akustische Oberflächenwellen-5-IDT-Filtereinheiten (410; 420) vom längsgekoppelten Resonatortyp, die kaskadiert geschaltet und auf dem piezoelektrischen Substrat angeordnet sind, und
wenigstens zwei akustische Oberflächenwellenresonatoren (31 a; 31 b), die auf dem piezoelektrischen Substrat angeordnet sind,
wobei jede der ersten und zweiten akustischen Oberflächenwellenfiltereinheiten (410; 420) eine erste IDT (411; 421) und zweite und dritte IDTs (412, 413; 422, 423), die auf beiden Seiten der ersten IDT in einer akustischen Oberflächenwellenausbreitungsrichtung angeordnet sind, vierte und fünfte IDTs (414, 415; 424, 425), die in der akustischen Oberflächenwellenausbreitungsrichtung auf beiden Seiten eines Bereichs angeordnet sind, in dem die ersten bis dritten IDTs angeordnet sind, und erste und zweite Reflektoren (416, 417; 426, 427) umfaßt, die in der akustischen Oberflächenwellenausbreitungsrichtung angeordnet sind, wobei jeweils die ersten IDTs der ersten und zweiten akustischen Oberflächenwellenfiltereinheiten (410; 420) erste und zweite IDT-Unterabschnitte (411 a, 411b; 421 a, 421 b) umfassen, die unter Halbieren der entsprechenden IDTs in der akustischen Oberflächenwellenausbreitungsrichtung angeordnet sind,
wobei die akustischen Oberflächenwellenausbreitungsrichtungen der ersten und zweiten akustischen Oberflächenwellenfiltereinheiten (410; 420) parallel zueinander verlaufen,
eine erste Signalleitung (6a), die die vierten IDTs (414; 424) der ersten und zweiten akustischen Oberflächenwellenfiltereinheiten elektrisch verbindet, eine zweite Signalleitung (7a), die die ersten IDT-Unterabschnitte (411a; 421 a) der ersten IDTs der ersten und zweiten akustischen Oberflächenwellenfiltereinheiten elektrisch verbindet, eine dritte Signalleitung (6b), die die zweiten IDT-Unterabschnitte (411b; 421 b) der ersten IDTs der ersten und zweiten akustischen Oberflächenwellenfiltereinheiten elektrisch verbindet, und eine vierte Signalleitung (7b), die die fünften IDTs (415; 425) der ersten und zweiten akustischen Oberflächenwellenfiltereinheiten elektrisch verbindet,
wobei eine Phase eines elektrischen Signals, das durch die erste Signalleitung (6a) läuft, von einer Phase eines elektrischen Signals, das durch die zweite Signalleitung (7a) läuft, um 180° verschoben ist, und eine Phase eines elektrischen Signals, das durch die dritte Signalleitung (6b) läuft, von einer Phase eines elektrischen Signals, das durch die vierte Signalleitung (7b) läuft, um 180° verschoben ist,
**dadurch gekennzeichnet, daß**
wenigstens einer (31 a; 31 b) der wenigstens zwei akustischen Oberflächenwellenresonatoren zwischen die erste Signalleitung (6a) und die zweite Signalleitung (7a) und zwischen die dritte Signalleitung (6b) und die vierte Signalleitung (7b) elektrisch geschaltet ist,
der Antiresonanzpunkt der wenigstens zwei akustischen Oberflächenwellenresonatoren innerhalb der Dämpfungsregion in der Nachbarschaft des Randes der Niedrigfrequenzseite des Durchlaßbandes der akustischen Oberflächenwellenfiltervorrichtung (401) plaziert ist und
der Resonanzpunkt der wenigstens zwei akustischen Oberflächenwellenresonatoren innerhalb des Durchlaßbandes der akustischen Oberflächenwellenfiltervorrichtung (401) plaziert ist.

5. Akustische Oberflächenwellenfiltervorrichtung nach einem der Ansprüche 1 bis 4, wobei die akustische Oberflächenwellenfiltervorrichtung eine Transformationsfunktion von symmetrisch zu unsymmetrisch aufweist, wobei die erste akustische Oberflächenwellenfiltereinheit (10; 410) mit einem unsymmetrischen Anschluß (3) verbunden ist und die zweite akustische Oberflächenwellenfiltereinheit (20; 420) mit ersten und zweiten symmetrischen Anschlüssen (4, 5) verbunden ist.

6. Akustische Oberflächenwellenfiltervorrichtung (101) nach einem der Ansprüche 1 bis 4, wobei die akustische Oberflächenwellenfiltervorrichtung ein Filter für unsymmetrische Signaleingabe und unsymmetrische Signalausgabe ist, wobei die erste akustische Oberflächenwellenfiltereinheit (110) mit einem ersten unsymmetrischen Anschluß (103) verbunden ist und die zweite akustische Oberflächenwellenfiltereinheit (120) mit einem zweiten unsymmetrischen Anschluß (104) verbunden ist.

7. Akustische Oberflächenwellenfiltervorrichtung (201) nach einem der Ansprüche 1 bis 4, wobei die akustische Oberflächenwellenfiltervorrichtung ein Filter für symmetrische Signaleingabe und symmetrische Signalausgabe ist, wobei die erste akustische Oberflächenwellenfiltereinheit (210) mit ersten und zweiten symmetrischen Anschlüssen (203a, 203b) verbunden ist und die zweite akustische Oberflächenwellenfiltereinheit (220) mit dritten und vierten symmetrischen Anschlüssen (204a, 204b) verbunden ist.

8. Duplexer (601), umfassend als einen Bandfilter die akustische Oberflächenwellenfiltervorrichtung (1) nach einem der Ansprüche 1 bis 7.

## Revendications

1. Dispositif de filtre à ondes acoustiques de surface (1) comprenant:
un substrat piézoélectrique (2),
une première et une deuxième unités de filtres à ondes acoustiques de surface (10, 20) du type résonateur à couplage longitudinal, connectées en cascade et disposées sur le substrat piézoélectrique, et
au moins un résonateur à ondes acoustiques de surface (31) disposé sur le substrat piézoélectrique,
dans lequel chacune des première et deuxième unités de filtres à ondes acoustiques de surface (10 / 20) comprend un premier IDT (transducteur interdigital) (11 / 21), ainsi qu'un deuxième et un troisième IDT (12, 13 / 22, 23) disposés de chaque côté du premier IDT dans une direction de propagation des ondes acoustiques de surface, un premier et un deuxième réflecteurs (14, 15 / 24, 25) disposés dans la direction de propagation des ondes acoustiques de surface de chaque côté d'une zone dans laquelle sont disposés les premier à troisième IDT, les directions de propagation des ondes acoustiques de surface des première et deuxième unités de filtres à ondes acoustiques de surface (10, 20) étant parallèles entre elles,
une première ligne de signal (6) connectant électriquement le deuxième IDT (12) de la première unité de filtre à ondes acoustiques de surface au deuxième IDT (22) de la deuxième unité de filtre à ondes acoustiques de surface, et
une deuxième ligne de signal (7) connectant électriquement le troisième IDT (13) de la première unité de filtre à ondes acoustiques de surface au troisième IDT (23) de la deuxième unité de filtre à ondes acoustiques de surface,
dans lequel un signal électrique circulant sur la première ligne de signal (6) est déphasé de 180° par rapport à un signal électrique circulant sur la deuxième ligne de signal (7),
**caractérisé en ce que** l'au moins un résonateur à ondes acoustiques de surface (31) est connecté entre la première ligne de signal (6) et la deuxième ligne de signal (7), le point de résonance de l'au moins un résonateur à ondes acoustiques de surface (31) est placé dans la région d'atténuation au voisinage du bord, côté fréquences basses, de la bande passante du dispositif de filtre à ondes acoustiques de surface (1), et le point d'antirésonance de l'au moins un résonateur à ondes acoustiques de surface (31) est placé dans la bande passante du dispositif de filtre à ondes acoustiques de surface (1).

2. Dispositif de filtre à ondes acoustiques de surface (1) comprenant :
un substrat piézoélectrique (2),
une première et une deuxième unités de filtres à ondes acoustiques de surface (10, 20) du type résonateur à couplage longitudinal, connectées en cascade et disposées sur le substrat piézoélectrique, et
au moins un résonateur à ondes acoustiques de surface (31) disposé sur le substrat piézoélectrique,
dans lequel chacune des première et deuxième unités de filtres à ondes acoustiques de surface (10 / 20) comprend un premier IDT (11 / 21), ainsi qu'un deuxième et un troisième IDT (12, 13 / 22, 23) disposés de chaque côté du premier IDT dans une direction de propagation des ondes acoustiques de surface, un premier et un deuxième réflecteurs (14, 15 / 24, 25) disposés dans la direction de propagation des ondes acoustiques de surface de chaque côté d'une zone dans laquelle sont disposés les premier à troisième IDT, les directions de propagation des ondes acoustiques de surface des première et deuxième unités de filtres à ondes acoustiques de surface (10, 20) étant parallèles entre elles,
une première ligne de signal (6) connectant électriquement le deuxième IDT (12) de la première unité de filtre à ondes acoustiques de surface au deuxième IDT (22) de la deuxième unité de filtre à ondes acoustiques de surface, et
une deuxième ligne de signal (7) connectant électriquement le troisième IDT (13) de la première unité de filtre à ondes acoustiques de surface au troisième IDT (23) de la deuxième unité de filtre à ondes acoustiques de surface,
dans lequel un signal électrique circulant sur la première ligne de signal (6) est déphasé de 180° par rapport à un signal électrique circulant sur la deuxième ligne de signal (7),
**caractérisé en ce que** l'au moins un résonateur à ondes acoustiques de surface (31) est connecté entre la première ligne de signal (6) et la deuxième ligne de signal (7), le point d'antirésonance de l'au moins un résonateur à ondes acoustiques de surface (31) est placé dans la région d'atténuation au voisinage du bord, côté fréquences hautes, de la bande passante du dispositif de filtre à ondes acoustiques de surface (1), et le point de résonance de l'au moins un résonateur à ondes acoustiques de surface (31) est placé dans la bande passante du dispositif de filtre à ondes acoustiques de surface (1).

3. Dispositif de filtre à ondes acoustiques de surface (401) comprenant :
un substrat piézoélectrique (402),
une première et une deuxième unités de filtres à ondes acoustiques de surface à 5 IDT (410, 420) du type résonateur à couplage longitudinal, connectées en cascade et disposées sur le substrat piézoélectrique, et
au moins deux résonateurs à ondes acoustiques de surface (31a, 31b) disposés sur le substrat piézoélectrique,
dans lequel chacune des première et deuxième unités de filtres à ondes acoustiques de surface (410 / 420) comprend un premier IDT (411 / 421), ainsi qu'un deuxième et un troisième IDT (412, 413 / 422, 423) disposés de chaque côté du premier IDT dans une direction de propagation des ondes acoustiques de surface, un quatrième et un cinquième IDT (414, 415 / 424, 425) disposés dans la direction de propagation des ondes acoustiques de surface de chaque côté d'une zone dans laquelle sont disposés les premier à troisième IDT, un premier et un deuxième réflecteurs (416, 417 / 426, 427) disposés dans la direction de propagation des ondes acoustiques de surface, chacun des premiers IDT des première et deuxième unités de filtres à ondes acoustiques de surface (410 / 420) comprenant des première et deuxième sous-parties d'IDT (411a, 411b / 421a, 421b) qui sont formés par séparation en deux des premiers IDT respectifs dans la direction de propagation des ondes acoustiques de surface,
les directions de propagation des ondes acoustiques de surface des première et deuxième unités de filtres à ondes acoustiques de surface (410, 420) étant parallèles entre elles,
une première ligne de signal (6a) connectant électriquement les quatrièmes IDT (414, 424) des première et deuxième unités de filtres à ondes acoustiques de surface, une deuxième ligne de signal (7a) connectant électriquement les premières sous-parties d'IDT (411a, 421a) des premiers IDT des première et deuxième unités de filtres à ondes acoustiques de surface, une troisième ligne de signal (6b) connectant électriquement les deuxièmes sous-parties d'IDT (411b, 421b) des premiers IDT des première et deuxième unités de filtres à ondes acoustiques de surface, et une quatrième ligne de signal (7b) connectant électriquement les cinquièmes IDT (415, 425) des première et deuxième unités de filtres à ondes acoustiques de surface,
dans lequel une phase d'un signal électrique circulant sur la première ligne de signal (6a) est déphasée de 180° par rapport à une phase d'un signal électrique circulant sur la deuxième ligne de signal (7a), et une phase d'un signal électrique circulant sur la troisième ligne de signal (6b) est déphasée de 180° par rapport à une phase d'un signal électrique circulant sur la quatrième ligne de signal (7b),
**caractérisé en ce que** :
au moins l'un (31a / 31b) des au moins deux résonateurs à ondes acoustiques de surface est connecté électriquement entre la première ligne de signal (6a) et la deuxième ligne de signal (7a), et entre la troisième ligne de signal (6b) et la quatrième ligne de signal (7b),
le point de résonance des au moins deux résonateurs à ondes acoustiques de surface est placé dans la région d'atténuation au voisinage du bord, côté fréquences basses, de la bande passante du dispositif de filtre à ondes acoustiques de surface (401), et
le point d'antirésonance des au moins deux résonateurs à ondes acoustiques de surface est placé dans la bande passante du dispositif de filtre à ondes acoustiques de surface (401).

4. Dispositif de filtre à ondes acoustiques de surface (401) comprenant :
un substrat piézoélectrique (402),
une première et une deuxième unités de filtres à ondes acoustiques de surface à 5 IDT (410, 420) du type résonateur à couplage longitudinal, connectées en cascade et disposées sur le substrat piézoélectrique, et
au moins deux résonateurs à ondes acoustiques de surface (31a, 31b) disposés sur le substrat piézoélectrique,
dans lequel chacune des première et deuxième unités de filtres à ondes acoustiques de surface (410 / 420) comprend un premier IDT (411 / 421), ainsi qu'un deuxième et un troisième IDT (412, 413 / 422, 423) disposés de chaque côté du premier IDT dans une direction de propagation des ondes acoustiques de surface, un quatrième et un cinquième IDT (414, 415 / 424, 425) disposés dans la direction de propagation des ondes acoustiques de surface de chaque côté d'une zone dans laquelle sont disposés les premier à troisième IDT, un premier et un deuxième réflecteurs (416, 417 / 426, 427) disposés dans la direction de propagation des ondes acoustiques de surface, chacun des premiers IDT des première et deuxième unités de filtres à ondes acoustiques de surface (410 / 420) comprenant des première et deuxième sous-parties d'IDT (411a, 411b / 421a, 421b) qui sont formés par séparation en deux des premiers IDT respectifs dans la direction de propagation des ondes acoustiques de surface,
les directions de propagation des ondes acoustiques de surface des première et deuxième unités de filtres à ondes acoustiques de surface (410, 420) étant parallèles entre elles,
une première ligne de signal (6a) connectant électriquement les quatrièmes IDT (414, 424) des première et deuxième unités de filtres à ondes acoustiques de surface, une deuxième ligne de signal (7a) connectant électriquement les premières sous-parties d'IDT (411a, 421a) des premiers IDT des première et deuxième unités de filtres à ondes acoustiques de surface, une troisième ligne de signal (6b) connectant électriquement les deuxièmes sous-parties d'IDT (411b, 421b) des premiers IDT des première et deuxième unités de filtres à ondes acoustiques de surface, et une quatrième ligne de signal (7b) connectant électriquement les cinquièmes IDT (415, 425) des première et deuxième unités de filtres à ondes acoustiques de surface,
dans lequel une phase d'un signal électrique circulant sur la première ligne de signal (6a) est déphasée de 180° par rapport à une phase d'un signal électrique circulant sur la deuxième ligne de signal (7a), et une phase d'un signal électrique circulant sur la troisième ligne de signal (6b) est déphasée de 180° par rapport à une phase d'un signal électrique circulant sur la quatrième ligne de signal (7b),
**caractérisé en ce que** :
au moins l'un (31a/31b) des au moins deux résonateurs à ondes acoustiques de surface est connecté électriquement entre la première ligne de signal (6a) et la deuxième ligne de signal (7a), et entre la troisième ligne de signal (6b) et la quatrième ligne de signal (7b),
le point d'antirésonance des au moins deux résonateurs à ondes acoustiques de surface est placé dans la région d'atténuation au voisinage du bord, côté fréquences hautes, de la bande passante du dispositif de filtre à ondes acoustiques de surface (401), et
le point de résonance des au moins deux résonateurs à ondes acoustiques de surface est placé dans la bande passante du dispositif de filtre à ondes acoustiques de surface (401).

5. Dispositif de filtre à ondes acoustiques de surface selon l'une des revendications 1 à 4, dans lequel le dispositif de filtre à ondes acoustiques de surface a une fonction de transformation entre équilibré et non-équilibré, avec la première unité de filtre à ondes acoustiques de surface (10 / 410) connectée à une borne non-équilibrée (3), et la deuxième unité de filtre à ondes acoustiques de surface (20 / 420) connectée à des première et deuxième bornes équilibrées (4, 5).

6. Dispositif de filtre à ondes acoustiques de surface (101) selon l'une des revendications 1 à 4, dans lequel le dispositif de filtre à ondes acoustiques de surface est un filtre à entrée de signal non-équilibrée et à sortie de signal non-équilibrée, avec la première unité de filtre à ondes acoustiques de surface (110) connectée à une première borne non-équilibrée (103) et la deuxième unité de filtre à ondes acoustiques de surface (120) connectée à une deuxième borne non-équilibrée (104).

7. Dispositif de filtre à ondes acoustiques de surface (201) selon l'une des revendications 1 à 4, dans lequel le dispositif de filtre à ondes acoustiques de surface est un filtre à entrée de signal équilibrée et à sortie de signal équilibrée, avec la première unité de filtre à ondes acoustiques de surface (210) connectée à des première et deuxième bornes équilibrées (203a, 203b) et la deuxième unité de filtre à ondes acoustiques de surface (220) connectée à une troisième et une quatrième bornes équilibrées (204a, 204b).

8. Duplexeur (601) comprenant en tant que filtre de bandes le dispositif de filtre à ondes acoustiques de surface (1) selon l'une des revendications 1 à 7.
